# DEMANDE DE BREVET EUROPEEN

(11) **EP 3 168 660 A1**
(43) Date de publication de la demande: **17.05.2017**
(21) Numéro de dépôt: 16195426.8
(22) Date de dépôt: 25.10.2016
(51) Int. Cl.: G02B 5/20, B82Y 20/00, H01L 31/0232, G03F 7/00

(54) **FILTRE OPTIQUE PLASMONIQUE**

(30) Priorité: 13.11.2015 FR 1560912
(71) Demandeur: COMMISSARIAT À L'ÉNERGIE ATOMIQUE ET AUX ÉNERGIES ALTERNATIVES, 75015 Paris (FR)
(72) Inventeur: BOUTAMI, Salim, 38100 Grenoble (FR); YON, Jean-Jacques, 38360 Sassenage (FR)
(74) Mandataire: Thibon, Laurent

(57) **Abrégé**

L'invention concerne un filtre optique plasmonique comprenant :
une répétition périodique de dalles métalliques (42) au-dessus d'une surface métallique (12) ;
des espaceurs diélectriques (36) disposés entre les dalles et la surface métallique de sorte qu'il existe un espace vide (38) entre chaque dalle et la surface métallique ; et
une ouverture (44) entre chacun desdits espaces vides et l'extérieur.

## Description

### Domaine

La présente demande concerne les filtres optiques, et tout particulièrement un filtre optique utilisant des résonateurs plasmoniques de type MIM (métal-oxyde-métal) pour transmettre ou absorber sélectivement un rayonnement optique.

### Exposé de l'art antérieur

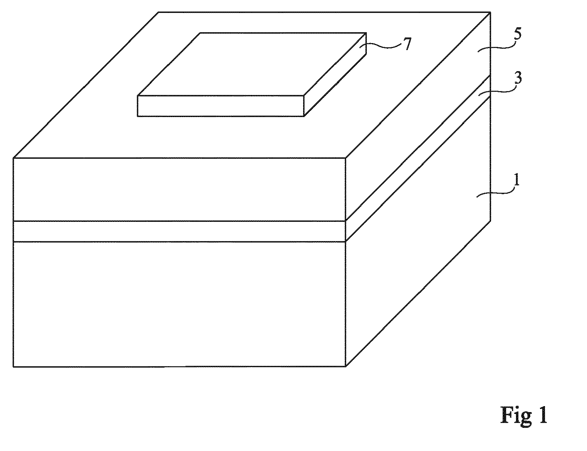

Des filtres optiques à résonateurs plasmoniques, ou filtres plasmoniques, sont utilisés pour transmettre ou absorber sélectivement un rayonnement optique de longueur d'onde choisie. Un filtre plasmonique peut par exemple être utilisé dans un bolomètre pour absorber sélectivement un rayonnement infrarouge. La figure 1 est une vue en perspective d'un résonateur plasmonique disposé à la surface d'une membrane 1 de bolomètre, correspondant à la figure 1 de "Multispectral microbolometers for the midinfrared", T. Maier et Al., Optics Letters Vol. 35 N° 22, 15 novembre 2010. Le résonateur comprend une couche métallique 3 sur laquelle s'étend une couche diélectrique 5 en nitrure de silicium recouverte d'une dalle métallique carrée. La dimension d des côtés de la dalle est égale à λ/2n, λ désignant la longueur d'onde, et n un indice effectif du mode plasmonique, voisin de l'indice de réfraction de la couche 5.

La qualité du filtrage est d'autant plus grande que la forme de la dalle, d'une dimension pouvant être submicronique, est réalisée avec précision. Or, les dalles de petites dimensions obtenues par les techniques de fabrication disponibles ont en réalité des angles arrondis et n'ont pas exactement les dimensions souhaitées. La qualité du filtrage obtenu est alors dégradée.

### Résumé

Ainsi, un mode de réalisation prévoit un filtre optique plasmonique comprenant une répétition périodique de dalles métalliques au-dessus d'une surface métallique ; des espaceurs diélectriques disposés entre les dalles et la surface métallique de sorte qu'il existe un espace vide entre chaque dalle et la surface métallique ; et une ouverture entre chacun desdits espaces vides et l'extérieur.

Selon un mode de réalisation, les dalles métalliques sont disposées en matrice et ont la forme de carrés dont les côtés ont une dimension comprise entre 0,3 µm et 3 µm.

Selon un mode de réalisation, les dalles métalliques ont une épaisseur comprise entre 30 nm et 100 nm et les espaceurs diélectriques ont une épaisseur comprise entre 30 nm et 300 nm.

Selon un mode de réalisation, les espaceurs diélectriques forment une grille délimitant lesdits espaces vides, l'intégralité de la périphérie de chaque dalle étant disposée sur la grille, et ladite ouverture étant formée dans chaque dalle.

Selon un mode de réalisation, les ouvertures ont des diamètres compris entre 10 et 40 nm.

Selon un mode de réalisation, la grille délimite des espaces vides de forme carrée.

Selon un mode de réalisation, la grille délimite des espaces vides circulaires.

Selon un mode de réalisation, les espaceurs diélectriques sont des plots disposés en matrice, chaque dalle ayant quatre coins disposés sur quatre plots voisins, les ouvertures étant des espaces entre les dalles.

Selon un mode de réalisation, les espaceurs diélectriques ont la forme de barres, chaque dalle ayant deux bords disposés sur deux barres voisines, les ouvertures étant des espaces entre les dalles.

Un mode de réalisation prévoit un procédé de réalisation d'un filtre optique plasmonique sur une surface métallique, comprenant les étapes suivantes :
a) déposer une couche diélectrique sur la surface métallique ;
b) former, sur la couche diélectrique, une répétition périodique de dalles métalliques disjointes, dont chacune est munie d'une ouverture ; et
c) éliminer une partie de la couche diélectrique par gravure sélective et isotrope à partir des ouvertures, en sorte de former des espaces vides sous chaque dalle métallique.

Selon un mode de réalisation, le procédé comprend, entre l'étape b) et l'étape c), une étape de masquage des portions de la couche diélectrique accessibles entre les dalles métalliques.

Selon un mode de réalisation, la couche diélectrique est en oxyde de silicium.

Un mode de réalisation prévoit un procédé de réalisation d'un filtre optique plasmonique sur une surface métallique, comprenant les étapes suivantes :
a) former une répétition périodique d'espaceurs diélectriques sur la surface métallique ;
b) remplir d'un matériau sacrificiel tout le volume situé entre les espaceurs ;
c) former une répétition périodique de dalles métalliques disjointes, chaque dalle reposant en majorité sur le matériau sacrificiel ; et
d) graver sélectivement le matériau sacrificiel à partir des ouvertures entre les dalles métalliques disjointes.

Selon un mode de réalisation, les espaceurs diélectriques sont en oxyde de silicium, le matériau sacrificiel est du nitrure de silicium, et la gravure sélective est une gravure RIE en milieu SF₆ et oxygène.

Selon un mode de réalisation, les espaceurs diélectriques sont en silicium, le matériau sacrificiel est de l'oxyde de silicium, et la gravure sélective est une gravure RIE sous plasma de CF₄ et d'oxygène.

Selon un mode de réalisation, les espaceurs diélectriques sont en oxyde de silicium, le matériau sacrificiel est du silicium, et la gravure sélective est une gravure RIE sous plasma de BCl₃, de Cl₂ et d'azote ou une gravure en phase sèche sous difluorure de xénon (XeF₂).

Selon un mode de réalisation, les espaceurs diélectriques sont en oxyde d'aluminium, le matériau sacrificiel est de l'oxyde de silicium, et la gravure sélective est une gravure chimique en phase vapeur par de l'acide fluorhydrique.

Un mode de réalisation prévoit un bolomètre comprenant un filtre tel que ci-dessus.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en perspective d'un résonateur plasmonique ;
les figures 2A à 2D illustrent des étapes d'un procédé de réalisation d'un filtre optique plasmonique ;
la figure 3 illustre l'absorption en fonction de la longueur d'onde par le filtre optique de la figure 2D.
la figure 4 est une vue partielle, en perspective avec coupe, d'une variante de filtre optique plasmonique ;
les figures 5A à 5D illustrent des étapes d'un procédé de réalisation d'une autre variante de filtre optique plasmonique ;
la figure 6 illustre l'absorption en fonction de la longueur d'onde par le filtre optique de la figure 5D ; et
la figure 7 est une vue partielle, en perspective avec coupe, d'une autre variante de filtre optique plasmonique.

### Description détaillée

De mêmes éléments ont été désignés par de mêmes références aux différentes figures et, de plus, les diverses figures ne sont pas tracées à l'échelle. Par souci de clarté, seuls les éléments qui sont utiles à la compréhension des modes de réalisation décrits ont été représentés et sont détaillés.

Dans la description qui suit, lorsque l'on fait référence à des qualificatifs de position relative, tels que les termes "dessus", "dessous", "supérieur", "sur", "sous", il est fait référence à l'orientation de l'élément concerné dans les figures. Sauf précision contraire, l'expression "de l'ordre de" signifie à 10 % près, de préférence à 5 % près.

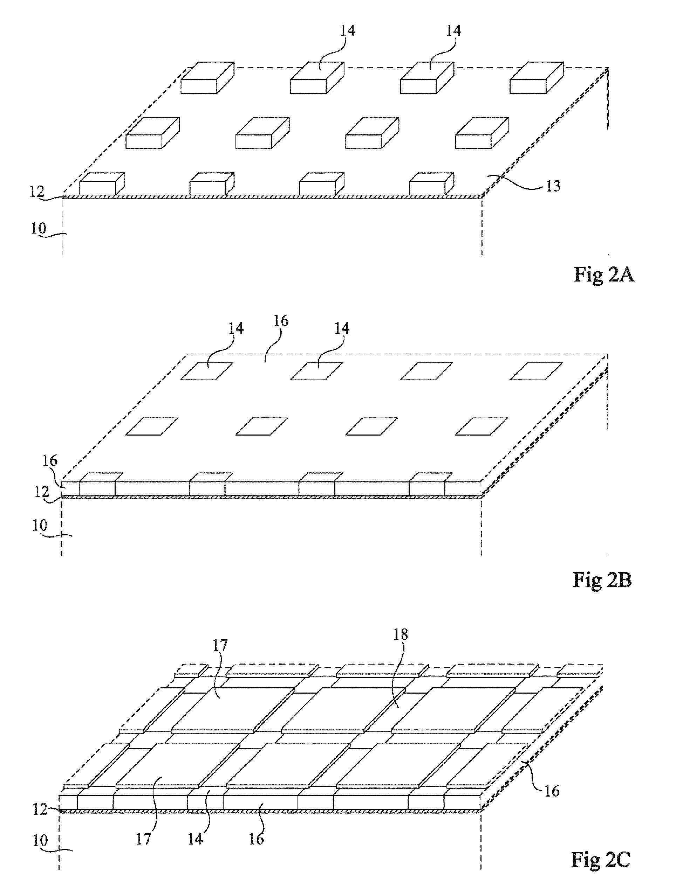

Les figures 2A à 2D sont des vues partielles, en perspective avec coupe, illustrant des étapes d'un procédé de réalisation d'un filtre optique plasmonique. Le filtre plasmonique est réalisé sur un support 10 ayant une surface supérieure métallique 13, par exemple une membrane de bolomètre recouverte d'une couche métallique 12.

A l'étape illustrée en figure 2A, des plots diélectriques 14 sont formés sur la surface métallique 13 du support 10. Les plots 14 ont une forme carrée et sont disposés en matrice. Les plots 14 sont réalisés par exemple par lithographie.

A l'étape illustrée en figure 2B, l'espace situé entre les plots est rempli d'un matériau sacrificiel 16, les plots 14 affleurant la surface supérieure du matériau sacrificiel 16. Pour réaliser ce remplissage, on peut déposer une couche de matériau sacrificiel sur la surface métallique 13 et sur les plots, puis polir la face supérieure de l'ensemble au moins jusqu'au niveau des plots 14 de façon à obtenir une surface plane.

A l'étape illustrée en figure 2C, des dalles carrées métalliques 17 disjointes sont formées sur la surface supérieure de l'ensemble, par exemple par lithographie. Les coins de chaque dalle sont disposés sur quatre plots 14 voisins, la dalle reposant majoritairement sur le matériau sacrificiel 16. Le dallage ainsi obtenu est régulier, et les dalles sont séparées par des espacements 18.

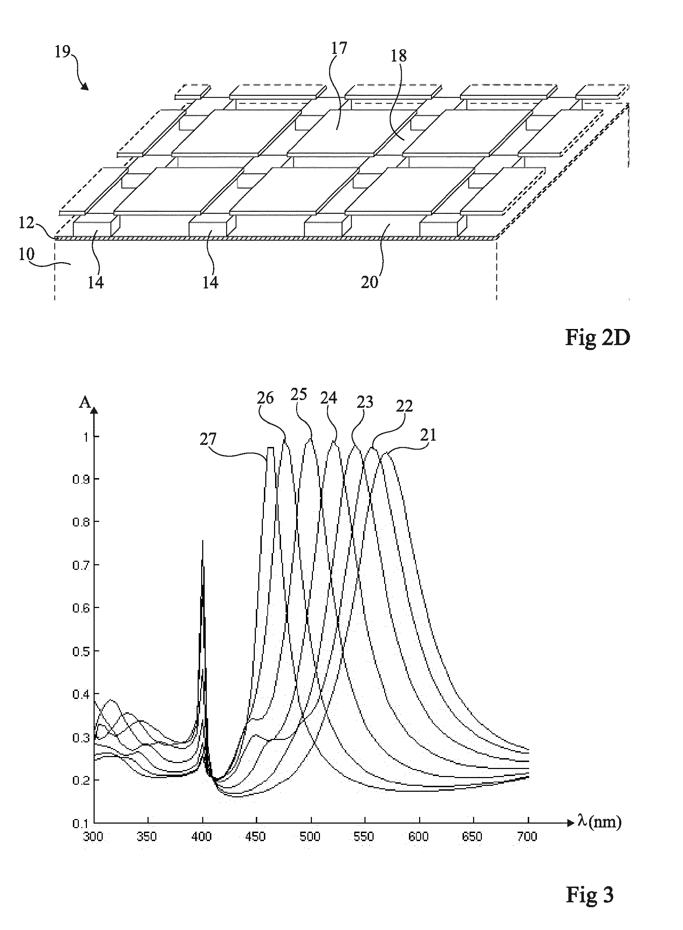

La figure 2D représente le filtre optique plasmonique 19 obtenu après une étape d'élimination du matériau sacrificiel 16 par gravure sélective. Chaque dalle est maintenue par les plots situés sous ses coins et la majeure partie de chaque dalle est suspendue au-dessus d'un espace vide 20. Les plots 14 ont la fonction d'espaceurs permettant de maintenir l'espace vide 20.

Comme on l'a indiqué précédemment, la dimension d des côtés des dalles est égale à λ/2n, λ désignant la longueur d'onde, et n désignant l'indice de réfraction du matériau situé sous chaque dalle. Or, n est maintenant égal à 1 sous la plus grande partie de chaque dalle. De ce fait, pour une longueur d'onde de filtrage donnée, les dalles 17 peuvent être jusqu'à n fois plus grandes que dans le cas où ces dalles reposent sur un matériau diélectrique. n est par exemple proche de 1,45 pour l'oxyde de silicium et proche de 2 pour le nitrure de silicium. Pour des dalles plus grandes, les formes sont réalisées avec plus de précision, et le filtre 19 de la figure 2D présente une meilleure précision sur la position du pic de filtrage réalisé par rapport à celui recherché.

La figure 3 représente des courbes 21 à 27 illustrant l'absorption A d'un rayonnement optique par des modes de réalisation de filtres selon le procédé des figures 2A à 2D, en fonction de la longueur d'onde λ du rayonnement. Les filtres diffèrent seulement par les dimensions de leurs plots 14, les dalles 17 étant identiques avec des espacements 18 identiques. Le filtre associé à la courbe 21 a les plots 14 les plus grands, et par conséquent les espaces vides 20 les plus petits. Le filtre associé à la courbe 27 a au contraire les plots 14 les plus petits, les espaces vides 20 étant les plus grands. On constate qu'avec des dalles de mêmes dimensions, on peut filtrer un rayonnement de longueur d'onde d'autant plus petite que les espaces vides 20 sous les plots sont grands.

A titre d'exemple, la couche métallique 12 et les dalles métalliques 17 sont en aluminium. Les plots 14 peuvent être en oxyde de silicium et le matériau sacrificiel peut être du nitrure de silicium, la gravure sélective de la couche sacrificielle pouvant être réalisée par gravure ionique réactive ou RIE (de l'anglais "Reactive Ion Etching") en milieu SF₆ et oxygène. Dans une variante, les plots 14 sont en silicium polycristallin, le matériau sacrificiel est de l'oxyde de silicium, et la gravure sélective est une gravure RIE sous plasma de CF₄ et d'oxygène. Dans une autre variante, les plots 14 sont en oxyde de silicium, le matériau sacrificiel est du silicium polycrictallin, et la gravure sélective est une gravure RIE sous plasma de BCl₃, de Cl₂ et d'azote ou une gravure en phase sèche sous difluorure de xénon (XeF₂). Dans une autre variante, les plots sont en oxyde d'aluminium, le matériau sacrificiel est de l'oxyde de silicium, et la gravure sélective est une gravure chimique en phase vapeur par de l'acide fluorhydrique. D'une manière plus générale, on peut choisir pour les plots et le matériau sacrificiel toute combinaison de deux matériaux auxquels un procédé de gravure sélective peut être adapté.

A titre d'exemple, la dimension d des côtés des dalles a une longueur comprise entre 0,2 µm et 3 µm, correspondant respectivement à une longueur d'onde de l'ordre de 0,4 à 6 µm. L'épaisseur des dalles peut être comprise entre 20 et 100 nm. L'épaisseur ou hauteur des plots peut être comprise entre 30 et 300 nm.

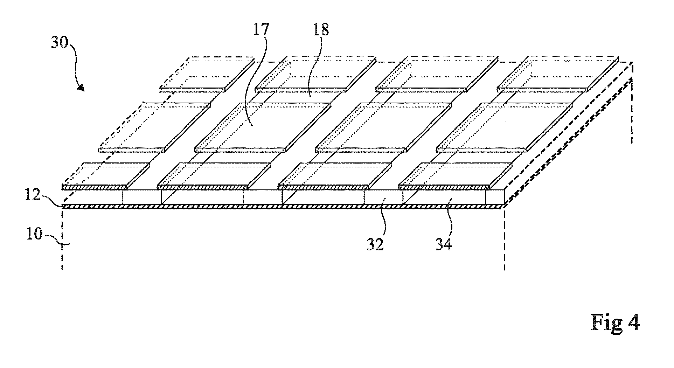

La figure 4 est une vue partielle, en perspective avec coupe, d'une variante de filtre optique plasmonique 30. Le filtre optique 30 correspond au filtre 19 de la figure 2D dans lequel les plots 14 ont été remplacés par des barres parallèles 32. Chaque dalle 17 forme un pont au-dessus de l'espace vide 34 situé entre deux barres.

Chaque dalle 17 du filtre 30 est maintenue par deux côtés, ce qui lui confère une tenue mécanique meilleure que celle des dalles du filtre 19 de la figure 2D qui ne sont tenues que par leurs coins. Cette tenue mécanique est avantageuse car le dispositif peut être soumis à des dilatations thermiques, à des pressions ou à des vibrations, susceptibles d'endommager les dalles. Cependant il y a une sensibilité à la polarisation dans ce mode de réalisation, car la structure n'a plus la symétrie rotationnelle de 90°.

On notera que les espaces vides situés sous les dalles 17 du filtre 30, ainsi que sous les dalles 17 du filtre 19 de la figure 2D, sont ouverts vers l'extérieur par les espacements 18 entre les dalles disjointes. Ainsi, lors d'une variation de pression ou de température, le gaz présent dans l'espace vide sous les dalles peut rentrer ou s'échapper librement, ce qui évite des contraintes mécaniques néfastes.

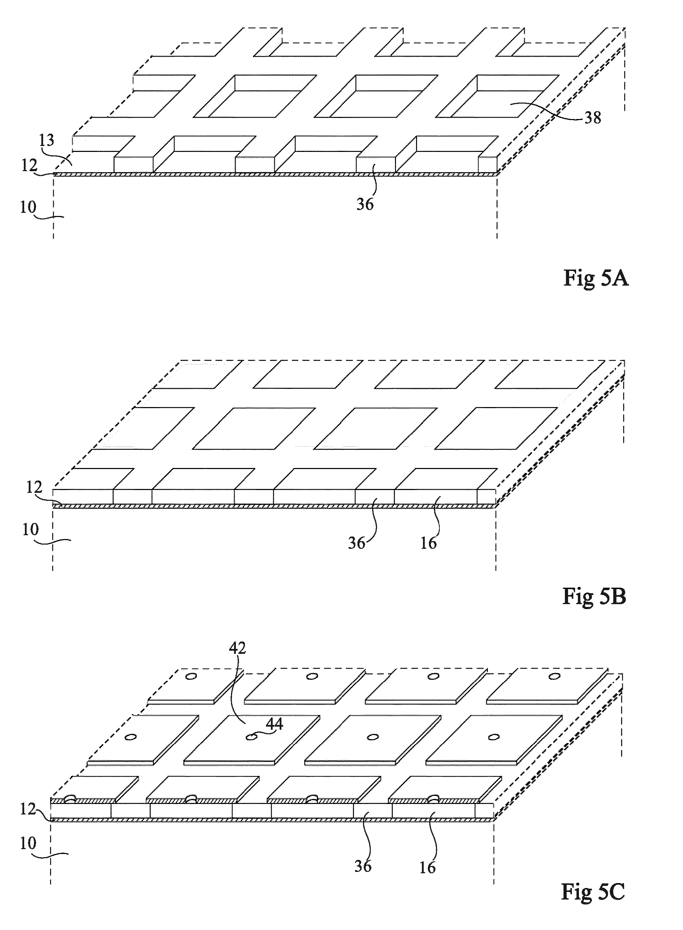

Les figures 5A à 5D sont des vues partielles, en perspective avec coupe, illustrant des étapes d'un procédé de réalisation d'une autre variante de filtre plasmonique sur la surface métallique 13 d'un support 10.

L'étape illustrée en figure 5A correspond à l'étape de la figure 2A, les plots 14 de la figure 2A ayant été remplacés par une structure en forme de grille 36 délimitant des espaces de forme carrée 38.

L'étape illustrée en figure 5B correspond à l'étape de la figure 2B. Les espaces 38 sont remplis d'un matériau sacrificiel 16.

L'étape illustrée en figure 5C correspond à l'étape de la figure 2C. Des dalles métalliques carrées 42 disjointes sont réalisées sur la surface supérieure de l'ensemble et forment un dallage régulier. Chaque dalle 42 recouvre le matériau sacrificiel situé dans un espace 38 et la périphérie de chaque dalle se situe en totalité sur la grille 36.

Chaque dalle 42 est munie d'une ouverture 44 située par exemple au centre de la dalle.

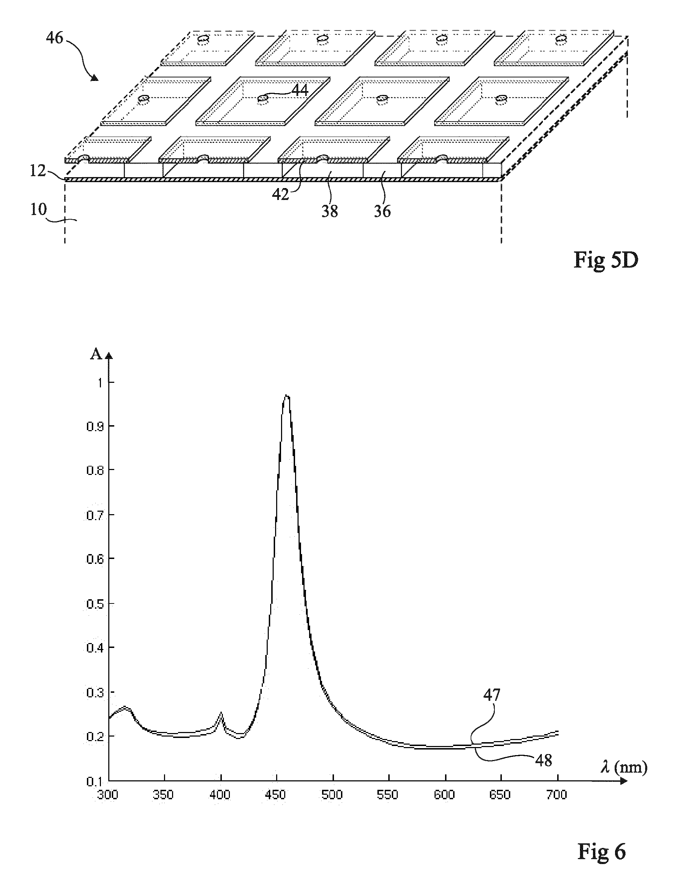

La figure 5D représente le filtre optique 46 obtenu après une étape de gravure sélective du matériau sacrificiel 16 à partir des ouvertures 44. La plus grande partie de chaque dalle est située au-dessus d'un espace vide 38.

Chaque espace vide 38 communique avec l'extérieur par l'ouverture 44 dans la dalle. Comme on l'a indiqué précédemment, ces ouvertures de communication permettent au filtre de résister mécaniquement aux variations de pression. En outre, chaque dalle est maintenant maintenue par l'intégralité de sa périphérie. Cette particularité confère avantageusement au filtre mécanique 46 une résistance mécanique remarquablement accrue. De plus, on conserve une insensibilité à la polarisation dans ce mode de réalisation, car la structure garde la symétrie rotationnelle de 90° (si les périodes en x et y sont égales).

Les ouvertures peuvent avoir une forme quelconque. A titre d'exemple, les ouvertures 44 sont circulaires de diamètres compris entre 10 et 40 nm. Les inventeurs ont constaté que la présence de telles ouvertures 44 a un effet négligeable sur les propriétés optiques du filtre.

Ceci est montré en figure 6, qui illustre des résultats de simulations. L'absorption 47 d'un rayonnement optique par un filtre 46 est comparée à l'absorption 48 par un filtre identique dans lequel les dalles seraient dépourvues d'ouvertures. La présence dans le filtre 46 d'ouvertures circulaires 44 de diamètres atteignant 40 nm dans des dalles ayant des côtés de seulement 300 nm augmente de moins de 2% l'intervalle des longueurs d'ondes absorbées. A fortiori, des ouvertures plus petites dans des dalles plus grandes ont des effets encore plus faibles.

Le filtre 46 est de qualité optique identique à celle des filtres 19 et 30 des figures 2D et 4, et résiste tout autant aux variations de pression, tout en étant doté d'une résistance mécanique remarquablement accrue. De plus, on conserve une insensibilité à la polarisation.

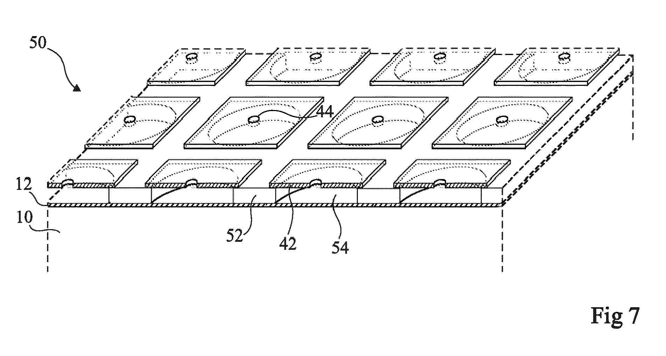

La figure 7 est une vue partielle, en perspective avec coupe, d'une autre variante d'un filtre optique plasmonique 50.

Le filtre optique 50 est réalisé en formant, sur une couche uniforme d'un matériau diélectrique 52 recouvrant la surface métallique 13 d'un support 10, un dallage régulier de dalles métalliques carrées 42 disjointes. Chaque dalle est munie d'une ouverture centrale 44. Le matériau diélectrique 52 est ensuite gravé sélectivement, de manière isotrope, à partir des ouvertures 44 afin de former un espace vide 54 sous la majeure partie de chacune des dalles 42. La gravure peut être effectuée après un masquage destiné à protéger les portions du matériau diélectrique 52 accessibles entre les dalles. Le filtre 50 obtenu correspond au filtre 46 de la figure 5D, dans lequel les espaces vides 38 de forme carrée ont été remplacés par les espaces vides 54 de forme circulaire. Le matériau diélectrique 52 restant constitue une structure en forme de grille délimitant des espaces circulaires. A titre d'exemple, le matériau diélectrique 52 peut être de l'oxyde de silicium.

Le filtre 50 présente l'avantage d'être réalisable de façon très simple.

Des modes de réalisation particuliers ont été décrits. Diverses variantes et modifications apparaîtront à l'homme de l'art. En particulier, la surface métallique 13 des modes de réalisation décrits est une surface continue sur laquelle les filtres plasmoniques réalisés sont des filtres en réflexion, c'est-à-dire absorbant un rayonnement optique de longueur d'onde choisie et réfléchissant les rayonnements optiques d'autres longueurs d'ondes. Des variantes de filtres plasmoniques transmettant un rayonnement de longueur d'onde choisie sont possibles, dans lesquelles le support métallique comprend des dalles métalliques disjointes formées sur un support transparent.

En outre, bien que les dalles des modes de réalisation décrits ci-dessus soient carrées, les dalles peuvent avoir d'autres formes adaptées à former des résonateurs plasmoniques. A titre d'exemple, les dalles peuvent être en forme de croix ou rondes. A titre de variante les dalles peuvent avoir des formes rectangulaires pour favoriser le filtrage de rayonnements de polarisation choisie.

De plus, bien que, dans les modes de réalisation décrits, les dalles soient disposées en matrice, les dalles peuvent être répétées périodiquement selon d'autres configurations. Par exemple, les dalles peuvent être disposées selon un réseau triangulaire.

## Revendications

1. Filtre optique plasmonique comprenant :
une répétition périodique de dalles métalliques (17 ; 42) au-dessus d'une surface métallique (13) ;
des espaceurs diélectriques (14 ; 32 ; 36 ; 52) disposés entre les dalles et la surface métallique de sorte qu'il existe un espace vide (20 ; 34 ; 38 ; 54) entre chaque dalle et la surface métallique ; et
une ouverture (18 ; 44) entre chacun desdits espaces vides et l'extérieur.

2. Filtre selon la revendication 1, dans lequel les dalles métalliques (17 ; 42) sont disposées en matrice et ont la forme de carrés dont les côtés ont une dimension comprise entre 0,3 µm et 3 µm.

3. Filtre selon la revendication 1 ou 2, dans lequel les dalles métalliques (17 ; 42) ont une épaisseur comprise entre 30 nm et 100 nm et les espaceurs diélectriques (14 ; 32 ; 36 ; 52) ont une épaisseur comprise entre 30 nm et 300 nm.

4. Filtre (46 ; 50) selon l'une quelconque des revendications 1 à 3, dans lequel les espaceurs diélectriques forment une grille (36 ; 52) délimitant lesdits espaces vides (38 ; 54), l'intégralité de la périphérie de chaque dalle (42) étant disposée sur la grille, et ladite ouverture (44) étant formée dans chaque dalle.

5. Filtre (46 ; 50) selon l'une quelconque des revendications 1 à 4, dans lequel les ouvertures (44) ont des diamètres compris entre 10 et 40 nm.

6. Filtre (46) selon la revendication 4 ou 5, dans lequel la grille (36) délimite des espaces vides (38) de forme carrée.

7. Filtre (50) selon la revendication 4 ou 5, dans lequel la grille (52) délimite des espaces vides (54) circulaires.

8. Filtre (19) selon l'une quelconque des revendications 1 à 3, dans lequel les espaceurs diélectriques sont des plots (14) disposés en matrice, chaque dalle (17) ayant quatre coins disposés sur quatre plots voisins, les ouvertures (18) étant des espaces entre les dalles.

9. Filtre (30) selon l'une quelconque des revendications 1 à 3, dans lequel les espaceurs diélectriques ont la forme de barres (32), chaque dalle (17) ayant deux bords disposés sur deux barres voisines, les ouvertures étant des espaces entre les dalles.

10. Procédé de réalisation d'un filtre optique plasmonique (50) sur une surface métallique (13), comprenant les étapes suivantes :
a) déposer une couche diélectrique (52) sur la surface métallique ;
b) former, sur la couche diélectrique, une répétition périodique de dalles métalliques (42) disjointes, dont chacune est munie d'une ouverture (44) ; et
c) éliminer une partie de la couche diélectrique par gravure sélective et isotrope à partir des ouvertures, en sorte de former des espaces vides (54) sous la majeure partie de chaque dalle métallique.

11. Procédé selon la revendication 10, comprenant, entre l'étape b) et l'étape c), une étape de masquage des portions de la couche diélectrique (52) accessibles entre les dalles métalliques (42).

12. Procédé selon la revendication 10 ou 11, dans lequel la couche diélectrique (52) est en oxyde de silicium.

13. Procédé de réalisation d'un filtre optique plasmonique (19 ; 30 ; 46) sur une surface métallique (13), comprenant les étapes suivantes :
a) former une répétition périodique d'espaceurs diélectriques (14 ; 32 ; 36) sur la surface métallique ;
b) remplir d'un matériau sacrificiel (16) tout le volume situé entre les espaceurs ;
c) former une répétition périodique de dalles métalliques (17) disjointes, chaque dalle reposant en majorité sur le matériau sacrificiel ; et
d) graver sélectivement le matériau sacrificiel à partir des ouvertures entre les dalles métalliques disjointes.

14. Procédé selon la revendication 13, dans lequel les espaceurs diélectriques (14 ; 32 ; 36) sont en oxyde de silicium, le matériau sacrificiel (16) est du nitrure de silicium, et la gravure sélective est une gravure RIE en milieu SF₆ et oxygène.

15. Procédé selon la revendication 13, dans lequel les espaceurs diélectriques (14 ; 32 ; 36) sont en silicium, le matériau sacrificiel (16) est de l'oxyde de silicium, et la gravure sélective est une gravure RIE sous plasma de CF₄ et d'oxygène.

16. Procédé selon la revendication 13, dans lequel les espaceurs diélectriques (14 ; 32 ; 36) sont en oxyde de silicium, le matériau sacrificiel (16) est du silicium, et la gravure sélective est une gravure RIE sous plasma de BCl₃, de Cl₂ et d'azote ou une gravure en phase sèche sous difluorure de xénon (XeF₂).

17. Procédé selon la revendication 13, dans lequel les espaceurs diélectriques (14 ; 32 ; 36) sont en oxyde d'aluminium, le matériau sacrificiel (16) est de l'oxyde de silicium, et la gravure sélective est une gravure chimique en phase vapeur par de l'acide fluorhydrique.

18. Bolomètre comprenant un filtre selon l'une quelconque des revendications 1 à 9.
